# EUROPEAN PATENT APPLICATION

(11) **EP 4 694 630 A2**
(43) Date of publication of application: **11.02.2026**
(21) Application number: 25219502.9
(22) Date of filing: 28.11.2025
(51) Int. Cl.: H10F 77/20, H10F 77/70

(54) **SOLAR CELL AND MANUFACTURING METHOD THEREOF**

(30) Priority: 10.12.2024 CN 202411814718
(71) Applicant: Jinko Solar (Shangrao) Co., Ltd, Jiangxi 334100 (CN); Jinko Solar (Haining) Co., Ltd., Haining City, Zhejiang 314415 (CN)
(72) Inventor: LV, Yanfeng, Shangrao, 334100 (CN); ZHANG, Yuanfang, Shangrao, 334100 (CN); WANG, Zhao, Shangrao, 334100 (CN); ZHENG, Peiting, Shangrao, 334100 (CN); YANG, Jie, Shangrao, 334100 (CN); ZHANG, Xinyu, Shangrao, 334100 (CN); FANG, Lingxin, Shangrao, 334100 (CN); GU, Wenxian, Shangrao, 334100 (CN)
(74) Representative: Haseltine Lake Kempner LLP

(57) **Abstract**

The present application relates to a solar cell and a manufacturing method thereof. The solar cell includes a substrate, a first electrode, and a second electrode. A front side of the substrate includes a first region and a second region. The first region has a first pyramid structure. The second region has a second pyramid structure. An apex of the first pyramid structure is higher than an apex of the second pyramid structure. The first region has a first diffusion-doped region. A back side of the substrate includes a third region and a fourth region. A tunnel layer and a doped semiconductor layer are sequentially stacked on a side of the third region away from the substrate. The fourth region has a third pyramid structure.

## Description

### TECHNICAL FIELD

The present application relates to the field of photovoltaic technology, and in particular, to a solar cell and a method for manufacturing the same.

### BACKGROUND

Tunnel oxide passivated contact (TOPCon) solar cells are mainstream solar cells in the photovoltaic field. An important topic for research and development of TOPCon solar cells is to reduce the reflective light loss of TOPCon solar cells, improve the photoelectric conversion efficiency of TOPCon solar cells, and enhance the power generation capability of TOPCon solar cells.

### SUMMARY

Based on this, it is necessary to provide a solar cell and a method for manufacturing the same to address the issue of reflective light loss in existing TOPCon solar cells.

To achieve the above object, in a first aspect, the present application provides a solar cell, including:

a substrate, wherein a front side of the substrate includes a first region and a second region that are arranged alternately, the first region has a first pyramid structure, the second region has a second pyramid structure, and in a direction from a back side of the substrate towards the front side of the substrate, an apex of the first pyramid structure is higher than an apex of the second pyramid structure, the first region has a first diffusion-doped region; the back side of the substrate includes a third region and a fourth region that are arranged alternately, the solar cell includes a tunnel layer and a doped semiconductor layer sequentially stacked on a side of the third region away from the substrate, and the fourth region has a third pyramid structure;
a first electrode disposed on the first region, the first electrode being electrically connected to the first diffusion-doped region; and
a second electrode disposed on the third region, the second electrode being electrically connected to the doped semiconductor layer.

Optionally, the solar cell further includes:
a front passivation layer disposed on the front side of the substrate, the front passivation layer covering the first diffusion-doped region of the first region and the substrate in the second region; and
a back passivation layer disposed on the back side of the substrate, the back passivation layer covering the doped semiconductor layer on the third region and the substrate in the fourth region.

Optionally, a projection of the first region on the substrate and a projection of the fourth region on the substrate have an overlapping region. A projection of the second region on the substrate and a projection of the third region on the substrate have an overlapping region.

Optionally, a width of the first region is in a range from 80 µm to 300 µm. A width of the second region is in a range from 450 µm to 900 µm. A width of the third region is in a range from 80 µm to 300 µm. A width of the fourth region is in a range from 450 µm to 900 µm.

Optionally, a ratio of the width of the first region to the width of the second region is in a range from 1:1 to 1:9. A ratio of the width of the third region to the width of the fourth region is in a range from 1:1 to 1:9.

Optionally, a size of a base of the first pyramid structure is larger than a size of a base of the second pyramid structure. A height of the first pyramid structure is greater than a height of the second pyramid structure.

Optionally, a length of a base edge of the third pyramid structure is in a range from 0.5 µm to 4 µm. A height of the third pyramid structure is in a range from 0.5 µm to 3 µm.

In a second aspect, the present application provides a method for manufacturing a solar cell, including:
providing a substrate, and texturing a front side of the substrate to form a first pyramid structure;
forming an initial doped region on the front side of the substrate;
removing a portion of the initial doped region at intervals, wherein a region where the initial doped region is retained serves as a first region, a region where the initial doped region is removed serves as a second region; and texturing the second region to form a second pyramid structure on the second region, wherein in a direction from a back side of the substrate towards the front side of the substrate, an apex of the first pyramid structure is higher than an apex of the second pyramid structure;
performing a drive-in diffusion on the initial doped region to form a first diffusion-doped region in the first pyramid structure;
sequentially forming a tunnel layer, an intrinsic semiconductor layer, and a second silicon glass layer on the back side of the substrate;
doping the intrinsic semiconductor layer to form a doped semiconductor layer;
removing a portion of the tunnel layer, the doped semiconductor layer, and the second silicon glass layer that are stacked on the back side of the substrate at intervals, wherein a region where the tunnel layer, the doped semiconductor layer, and the second silicon glass layer are retained serves as a third region, and a region where the tunnel layer, the doped semiconductor layer, and the second silicon glass layer are removed serves as a fourth region;
texturing the fourth region to form a third pyramid structure on the fourth region;
removing the second silicon glass layer on the third region;
forming a front passivation layer to cover the first diffusion-doped region of the first region and the substrate in the second region, and forming a back passivation layer to cover the doped semiconductor layer on the third region and the substrate in the fourth region;
forming a first electrode on the first region, the first electrode being electrically connected to the first diffusion-doped region; and
forming a second electrode on the third region, the second electrode being electrically connected to the doped semiconductor layer.

Optionally, removing a portion of the initial doped region at intervals includes: irradiating the initial doped region in the second region with laser, and then texturing the second region to remove the initial doped region in the second region and simultaneously form the second pyramid structure on the second region.

Removing a portion of the tunnel layer, the doped semiconductor layer, and the second silicon glass layer that are stacked on the back side of the substrate at intervals includes: irradiating the tunnel layer, the doped semiconductor layer, and the second silicon glass layer on the fourth region with laser, removing the second silicon glass layer on the fourth region by washing with an acidic solution, and removing the tunnel layer and the doped semiconductor layer on the fourth region during texturing the fourth region.

Optionally, after performing the drive-in diffusion on the initial doped region, an oxide layer is formed on a surface of the second region, and simultaneously a first silicon glass layer is formed on a side of the first diffusion-doped region away from the substrate.

Optionally, at the time of removing the tunnel layer and the doped semiconductor layer on the fourth region, the oxide layer and the first silicon glass layer are removed.

According to the solar cell and the manufacturing method thereof in the present application, by providing the first pyramid structure on the first region of the front side and providing the second pyramid structure on the second region of the front side, and making the apex of the first pyramid structure higher than the apex of the second pyramid structure, reflective light loss on the front side is reduced; and by providing the third pyramid structure on the fourth region of the back side, reflective light loss on the back side is also reduced, thereby improving the short-circuit current output and overall photoelectric conversion efficiency of the solar cell, and improving the bifaciality of the solar cell.

### BRIEF DESCRIPTION OF THE DRAWINGS

To describe the technical solutions in the embodiment of the present application or in the prior art more clearly, the following briefly introduces the accompanying drawings required for describing the embodiments or the prior art. Apparently, the accompanying drawings in the following description show only some embodiments of the present application, and a person of ordinary skill in the art may still derive other drawings from these accompanying drawings without creative efforts.
FIG. 1 is a schematic structural view of a solar cell provided in an embodiment.
FIG. 2 is a process flowchart of a method for manufacturing a solar cell provided in an embodiment.
FIG. 3 is a schematic view of a substrate in an embodiment.
FIG. 4 is a schematic view after texturing a front side of a substrate to form a first pyramid structure in an embodiment.
FIG. 5 is a schematic view after forming an initial doped region in the first pyramid structure in an embodiment.
FIG. 6 is a schematic view after laser irradiation of the initial doped region in a second region in an embodiment.
FIG. 7 is a schematic view after removing the initial doped region in the second region and forming a second pyramid structure on the second region in an embodiment.
FIG. 8 is a schematic view after forming an oxide layer and a first silicon glass layer to protect the front side of the substrate in an embodiment.
FIG. 9 is a schematic view after polishing a back side of the substrate in an embodiment.
FIG. 10 is a schematic view after sequentially forming a tunnel layer, an intrinsic semiconductor layer, and a second silicon glass layer on the back side of the substrate in an embodiment.
FIG. 11 is a schematic view after doping the intrinsic semiconductor layer to form a doped semiconductor layer in an embodiment.
FIG. 12 is a schematic view after laser irradiation of the second silicon glass layer on a fourth region in an embodiment.
FIG. 13 is a schematic view after removing the tunnel layer, the doped semiconductor layer, and the second silicon glass layer on the fourth region, and texturing the fourth region to form a third pyramid structure in an embodiment.
FIG. 14 is a schematic view after forming a front passivation layer and a back passivation layer in an embodiment.

### REFERENCE NUMERALS

20: substrate; 31: first pyramid structure; 32: second pyramid structure; 33: third pyramid structure; 41: first diffusion-doped region; 41a: initial doped region; 42: front passivation layer; 421: first front passivation layer; 422: second front passivation layer; 43: oxide layer; 44: first silicon glass layer; 50: first electrode; 61: tunnel layer; 62: doped semiconductor layer; 62a: intrinsic semiconductor layer; 63: second silicon glass layer; 64: back passivation layer; 641: first back passivation layer; 642: second back passivation layer; 70: second electrode; A1: first region; B1: second region; A2: third region; B2: fourth region.

### DETAILED DESCRIPTION

To facilitate understanding of the present application, the present application will be described more comprehensively hereinafter with reference to the accompanying drawings. Preferred embodiments of the present application are shown in the drawings. However, the present application may be implemented in many different forms and is not limited to the embodiments described herein. Rather, these embodiments are provided so that the disclosure of the present application will be thorough and complete.

Unless otherwise defined, all technical and scientific terms used herein have the same meanings as commonly understood by one of ordinary skill in the art to which this application belongs. The terms used herein in the description of the present application are for the purpose of describing specific embodiments only and are not intended to limit the present application.

In the description of the present application, it should be understood that the terms "center", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential" etc. indicate the orientations or positional relationships on the basis of the drawings. These terms are only for the convenience of describing the present application and simplifying the description, rather than indicating or implying that the related devices or element must have the specific orientations, or be constructed or operated in the specific orientations, and therefore cannot be understood as limitations of the present application.

In addition, the terms "first" and "second" are only used for descriptive purposes and cannot be understood as indicating or implying relative importance or implicitly indicating the quantity or order of the indicated technical features. Therefore, the features modified by "first" or "second" may explicitly or implicitly include at least one of the features. In the description of the present application, the "plurality" or "multiple" means at least two, such as two, three, etc., unless otherwise specifically defined.

In the present application, unless otherwise specifically defined, a first feature, when being referred to as being located "on" or "under" a second feature, may be in direct contact with the second feature or in indirect contact with the second feature via an intermediate medium. Moreover, a first feature, when being referred to as being located "on", "above", "over" a second feature, may be located right above or obliquely above the second feature, or merely located at a horizontal level higher than the second feature. A first feature, when being referred to as being located "under", "below", "beneath" a second feature, may be located right below or obliquely below the second feature, or merely located at a horizontal level lower than the second feature.

It should be noted that an element, when being referred to as being "fixed" or "mounted" to another element, may be directly fixed or mounted to the other element or via an intermediate element. An element, when being referred to as being "connected" to another element, may be directly connected to the other element or via an intermediate element. Such terms as "vertical", "horizontal", "up", "down", "left", "right" and the like used herein are for illustrative purposes only and are not meant to be the only ways for implementing the present application.

Currently, the back side of TOPCon solar cells adopts a polished design to reduce defects on the back side of the cell and to make the back side smooth. However, the polished back side also causes part of the light to be reflected at the back side of the cell, so that the light cannot be captured by the cell and cannot be converted into electrical energy, exacerbating reflective light loss and reducing the short-circuit current output and overall photoelectric conversion efficiency of the TOPCon solar cell. More critically, the polished design of the back side limits the bifacial power generation capability of the cell, causing the performance of the TOPCon solar cell under bifacial illumination conditions to be unsatisfactory, and thus limiting the bifaciality of the TOPCon solar cell.

Term "bifaciality" refers to a ratio of the power generation efficiency of the back side to that of the front side of the cell, and is an important indicator for measuring the power generation performance of the cell under different illumination conditions, especially when the back side is also illuminated. An increase in reflective light loss means that the light energy received by the back side is reduced, thereby decreasing the power generation efficiency of the back side and further reducing the overall bifaciality of the cell.

In the present application, the "first region" refers to a functional region (i.e., an electrode region) on the front side of the substrate and used to set an electrode or form contact with an electrode, on which a doped structure or a conductive layer is disposed for collection of carriers.

In the present application, the "second region" refers to a non-functional region (i.e., a non-electrode region) on the front side of the substrate where no electrode is disposed, which is used to enhance optical performance but does not directly participate in electrode contact.

In the present application, the "third region" refers to a functional region (i.e., an electrode region) on the back side of the substrate and used to set an electrode or form contact with an electrode, on which a doped structure or a conductive layer is disposed for collection of carriers.

In the present application, the "fourth region" refers to a non-functional region (i.e., a non-electrode region) on the back side of the substrate where no electrode is disposed, which is used to enhance optical performance but does not directly participate in electrode contact.

In solar cells, the "pyramid structure" is a common surface texturing design, which uses a chemical texturing process to create micron-sized pyramid-shaped protrusions on the surface of a silicon substrate. For an ideal pyramid-shaped protrusion, the "apex" refers to the top or highest point of a pyramid-shaped protrusion. The "base" refers to the bottom plane or base portion of a pyramid-shaped protrusion. The "base edge" refers to one of the straight-line edges that form the boundary of the base (typically a polygon) of a pyramid-shaped protrusion. The "height" refers to the vertical distance from the base to the apex.

In the present application, "a size of a base" refers to a geometric dimension of the base of the pyramid structure, which is used to represent the size of the base surface of the pyramid structure. The size of the base can include, but is not limited to, a length of a base edge of the pyramid structure, a length of a diagonal of the pyramid structure, or an area of the base of the pyramid structure. Those skilled in the art can select appropriate parameters as the representation of the size of the base based on actual processes, measurement methods, or design requirements.

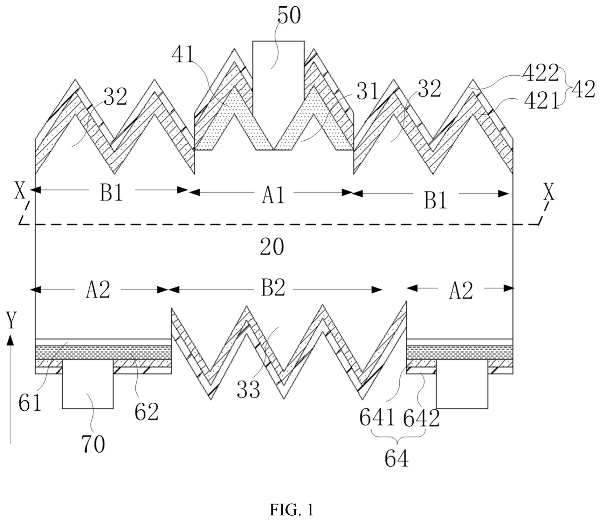

In view of this, the present application provides a solar cell. The solar cell may be a TOPCon solar cell. As shown in FIG. 1, the solar cell includes a substrate 20, a first electrode 50, and a second electrode 70. The substrate 20 can be a silicon substrate. The substrate 20 can be doped with N-type conductive ions. A front side of the substrate 20 includes first regions A1 and second regions B1 that are arranged alternately. The first regions A1 have first pyramid structures 31. The second regions B1 have second pyramid structures 32. In a direction Y from a back side of the substrate 20 towards the front side of the substrate 20, apexes of the first pyramid structures 31 are higher than apexes of the second pyramid structures 32. The first region A1 has a first diffusion-doped region 41. The direction Y is the thickness direction of the substrate 20. It can be understood that the substrate 20 has a plane X-X, the plane X-X is located inside the substrate 20 and the plane X-X is perpendicular to the direction Y. Along the direction Y, the plane X-X is located between the front side and the back side of the substrate 20. A distance between the apex of the first pyramid structure 31 and the plane X-X is greater than a distance between the apex of the second pyramid structure 32 and the plane X-X. The back side of the substrate 20 includes third regions A2 and fourth regions B2 that are arranged alternately. The solar cell includes a tunnel layer 61 and a doped semiconductor layer 62 sequentially stacked on a side of the third region A2 away from the substrate 20. The fourth region B2 has a third pyramid structure 33. The first electrode 50 is disposed on the first region A1, and the first electrode 50 is electrically connected to the first diffusion-doped region 41. The second electrode 70 is disposed on the third region A2, and the second electrode 70 is electrically connected to the doped semiconductor layer 62.

The front side of the substrate 20 includes first regions A1 and second regions B1 that are arranged alternately. The first pyramid structures 31 are formed on the first regions A1. The second pyramid structures 32 are formed on the second regions B1. That is, both the first regions A1 and the second regions B1 have pyramid structures to reduce light reflection on the front side of the cell.

In the direction Y from the back side of the substrate 20 towards the front side of the substrate 20, the apexes of the second pyramid structures 32 are lower than the apexes of the first pyramid structures 31, so that part of the light reflected by the second pyramid structures 32 is reflected to the first pyramid structures 31, absorbed by the first pyramid structures 31 and then converted into electrical energy, improving the ability of the cell to capture light from the front side, reducing reflective light loss on the front side of the cell, converting more light energy into electrical energy, and improving the short-circuit current output and overall photoelectric conversion efficiency of the solar cell.

Further, in the direction Y from the back side of the substrate 20 towards the front side of the substrate 20, the apexes of the second pyramid structures 32 can be lower than the apexes of the first pyramid structures 31. In this way, light reflected by the second pyramid structures 32 to the first pyramid structures 31 can be increased, reducing reflective light loss on the front side of the cell.

The first pyramid structure 31 is formed with the first diffusion-doped region 41. The first diffusion-doped region 41 can be a doped region of P-type conductive ions. The first diffusion-doped region 41 and the substrate 20 form a PN junction. The first electrode 50 is disposed on a side of the first region A1 away from the substrate 20. The first electrode 50 is electrically connected to the first diffusion-doped region 41, forming a current path.

The back side of the substrate 20 includes third regions A2 and fourth regions B2 that are arranged alternately. The fourth regions B2 have third pyramid structures 33. The third pyramid structures 33 can reduce reflective light loss on the fourth regions B2. More light incident on the back side of the cell is converted into electrical energy, improving the short-circuit current output and overall photoelectric conversion efficiency of the solar cell, and improving the bifaciality of the solar cell.

For example, a length of a base edge of the third pyramid structure 33 is in a range from 0.5 µm to 4 µm. For example, a height of the third pyramid structure 33 is in a range from 0.5 µm to 3 µm. For example, the length of the base edge of the third pyramid structure 33 can be 0.5 µm, 0.8 µm, 1 µm, 1.5 µm, 1.8 µm, 2 µm, 2.5 µm, 3 µm, 3.5 µm, 4 µm, or a value within a range defined by any two of the above range. For example, the height of the third pyramid structure 33 can be 0.5 µm, 1 µm, 1.5 µm, 2 µm, 2.5 µm, 3 µm, or a value within a range defined by any two of the above range.

The tunnel layer 61 and the doped semiconductor layer 62 are sequentially stacked on a side of the third region A2 away from the substrate 20. The doped semiconductor layer 62 can be an intrinsic semiconductor layer 62a doped with N-type conductive ions. For example, the doped semiconductor layer 62 can be an n-poly layer. The second electrode 70 is electrically connected to the doped semiconductor layer 62, forming a current path.

For the solar cell in the embodiments, by providing the first pyramid structures 31 on the first regions A1 of the front side and providing the second pyramid structures 32 on the second regions B1 of the front side, and making the apex of the first pyramid structures31 higher than the apex of the second pyramid structure 32, reflective light loss on the front side is reduced; and by providing the third pyramid structure 33 on the fourth region B2 of the back side, reflective light loss on the back side is reduced, thereby improving the short-circuit current output and overall photoelectric conversion efficiency of the solar cell, and improving the bifaciality of the solar cell.

In some embodiments, as shown in FIG. 1, a surface layer of the second region B1 is the substrate 20, without the first diffusion-doped region 41. That is, on the front side of the cell, the first diffusion-doped region 41 is only formed in the first region A1, and the PN junction only exists in the first region A1. This helps to reduce lifetime loss of minority carriers caused by Auger recombination and also improves the photoelectric conversion efficiency of the cell.

Auger recombination is a non-radiative recombination process and is the inverse process of "impact ionization". In a solar cell, when majority carriers recombine with minority carriers, the majority carriers or minority carriers transfer energy or momentum to another minority carrier or majority carrier through collision, causing that the minority carrier or majority carrier to undergo a transition.

In some embodiments, as shown in FIG. 1, the solar cell further includes a front passivation layer 42. The front passivation layer 42 is disposed on the front side of the substrate 20. The front passivation layer 42 covers the first diffusion-doped region 41 of the first region A1 and the substrate 20 in the second region B1. The front passivation layer 42 is configured to protect the front side of the solar cell, reduce surface recombination loss, and improve the photoelectric conversion efficiency and stability of the solar cell.

The front passivation layer 42 can include at least one of an aluminum oxide layer, a silicon oxide layer, or a silicon nitride layer. Alternatively, the front passivation layer 42 can include multiple stacked layers.

For example, the front passivation layer 42 can include a first front passivation layer 421 and a second front passivation layer 422 sequentially stacked on the front side of the substrate 20. The first front passivation layer 421 is an aluminum oxide layer. The second front passivation layer 422 is a silicon nitride layer. The aluminum oxide layer can effectively block impurities and moisture in the external environment from eroding the interior of the cell. Meanwhile, the aluminum oxide layer can also reduce the number of dangling bonds on the surface of the substrate 20, thereby reducing the surface recombination rate and improving the open-circuit voltage and short-circuit current of the cell. The aluminum oxide layer also has good light transmittance, reducing light transmission loss on the front side. The silicon nitride layer has good light transmittance and antireflection capability, which can reduce light transmission loss and refractive light loss on the front side of the cell. The silicon nitride layer also has good insulation performance and corrosion resistance, which can further reduce recombination loss on the surface of the substrate 20, so that more light incident on the front side of the substrate 20 can be absorbed by the solar cell and converted into electrical energy.

As shown in FIG. 1, the solar cell further includes a back passivation layer 64. The back passivation layer 64 is disposed on the back side of the substrate 20. The back passivation layer 64 covers the doped semiconductor layer 62 on the third region A2 and the substrate 20 in the fourth region B2.

That is, in the embodiments, the tunnel layer 61, the doped semiconductor layer 62, and the back passivation layer 64 are sequentially stacked on the bottom of the third region A2, while the bottom of the fourth region B2 is only provided with the back passivation layer 64 disposed thereon. This ensures stability of the electrical performance of the fourth regions B2, avoiding unnecessary current leakage or interference.

The back passivation layer 64 can include at least one of an aluminum oxide layer, a silicon oxide layer, or a silicon nitride layer. Alternatively, the back passivation layer 64 can include multiple stacked layers.

For example, the back passivation layer 64 includes a first back passivation layer 641 and a second back passivation layer 642 sequentially stacked on the back side of the substrate 20. The first back passivation layer 641 is an aluminum oxide layer, and the second back passivation layer 642 is a silicon nitride layer.

In some embodiments, as shown in FIG. 1, a projection of the first region A1 on the substrate 20 and a projection of the fourth region B2 on the substrate 20 have an overlapping region, and a projection of the second region B1 on the substrate 20 and a projection of the third region A2 on the substrate 20 have an overlapping region.

In this way, charge recombination loss caused by metallized electrodes can be reduced. Meanwhile, the second region B1 and the fourth region B2 can more effectively absorb light and convert the light into electric current, while the first region A1 and the third region A2 help to collect the electric current, reducing loss and optimizing the light absorption performance of the solar cell.

In some embodiments, as shown in FIG. 1, the projection of the first region A1 on the substrate 20 falls within the range of the projection of the fourth region B2 on the substrate 20. The projection of the third region A2 on the substrate 20 falls within the range of the projection of the second region B1 on the substrate 20. In this way, recombination loss can be reduced, charge collection can be optimized, and the light absorption performance and reliability of the solar cell can be improved.

In some embodiments, the projection of the first region A1 on the substrate 20 overlaps with the projection of the fourth region B2 on the substrate 20, and the projection of the second region B1 on the substrate 20 overlaps with the projection of the third region A2 on the substrate 20.

In some embodiments, as shown in FIG. 1, a width of the first region A1 is in a range from 80 µm to 300 µm. For example, the width of the first region A1 can be 80 µm, 100 µm, 120 µm, 150 µm, 200 µm, 220 µm, 250 µm, 280 µm, or 300 µm. A width of the second region B1 is in a range from 450 µm to 900 µm. For example, the width of the second region B1 can be 450 µm, 480 µm, 500 µm, 550 µm, 600 µm, 650 µm, 700 µm, 750 µm, 800 µm, 850 µm, or 900 µm.

A width of the third region A2 is in a range from 80 µm to 300 µm. For example, the width of the third region A2 can be 80 µm, 100 µm, 120 µm, 150 µm, 200 µm, 220 µm, 250 µm, 280 µm, or 300 µm. A width of the fourth region B2 is in a range from 450 µm to 900 µm. For example, the width of the fourth region B2 can be 450 µm, 480 µm, 500 µm, 550 µm, 600 µm, 650 µm, 700 µm, 750 µm, 800 µm, 850 µm, or 900 µm.

It should be noted that although the width ranges of the first region A1 and the third region A2 are the same, the widths of the first region A1 and the third region A2 can be different. Similarly, the widths of the second region B1 and the fourth region B2 can be different.

In some embodiments, a ratio of the width of the first region A1 to the width of the second region B1 is in a range from 1:1 to 1:9. For example, the ratio of the width of the first region A1 to the width of the second region B1 can be 1:1, 1:2, 1:3, 1:4, 1:5, 1:6, 1:7, 1:8, or 1:9. A ratio of the width of the third region A2 to the width of the fourth region B2 is in a range from 1:1 to 1:9. For example, the ratio of the width of the third region A2 to the width of the fourth region B2 can be 1:1, 1:2, 1:3, 1:4, 1:5, 1:6, 1:7, 1:8, or 1:9.

A size of a base of the first pyramid structure 31 is larger than a size of a base of the second pyramid structure 32. A height of the first pyramid structure 31 is greater than a height of the second pyramid structure 32.

A length of a base edge of the first pyramid structure 31 is in a range from 0.5 µm to 4 µm. A height of the first pyramid structure 31 is in a range from 0.5 µm to 3 µm.

A length of a base edge of the second pyramid structure 32 is in a range from 0.5 µm to 4 µm. A height of the second pyramid structure 32 is in a range from 0.5 µm to 3 µm.

In one example, the length of the base edge of the first pyramid structure 31 is 0.6 µm, and the height of the first pyramid structure 31 is 3 µm. The length of the base edge of the second pyramid structure 32 is 0.5 µm, and the height of the second pyramid structure 32 is 2 µm. In another example, the length of the base edge of the first pyramid structure 31 is 4 µm, and the height of the first pyramid structure 31 is 2.5 µm. The length of the base edge of the second pyramid structure 32 is 3 µm, and the height of the second pyramid structure 32 is 1.5 µm. In yet another example, the length of the base edge of the first pyramid structure 31 is 1.5 µm, and the height of the first pyramid structure 31 is 1.5 µm. The length of the base edge of the second pyramid structure 32 is 0.5 µm, and the height of the second pyramid structure 32 is 0.5 µm.

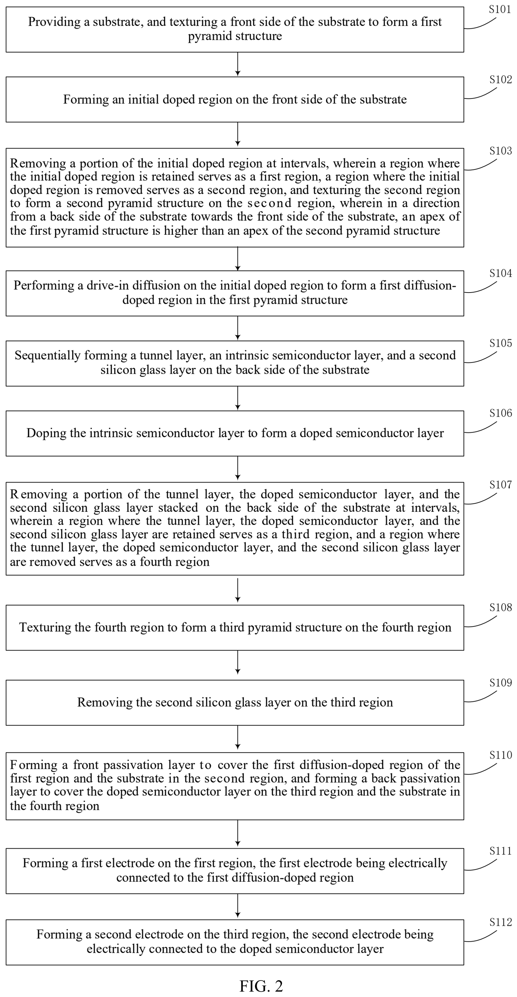

According to an exemplary embodiment, the present embodiment provides a method for manufacturing a solar cell. As shown in FIG. 2, the method for manufacturing the solar cell includes the following steps.

Step S101: providing a substrate, and texturing a front side of the substrate to form a first pyramid structure.

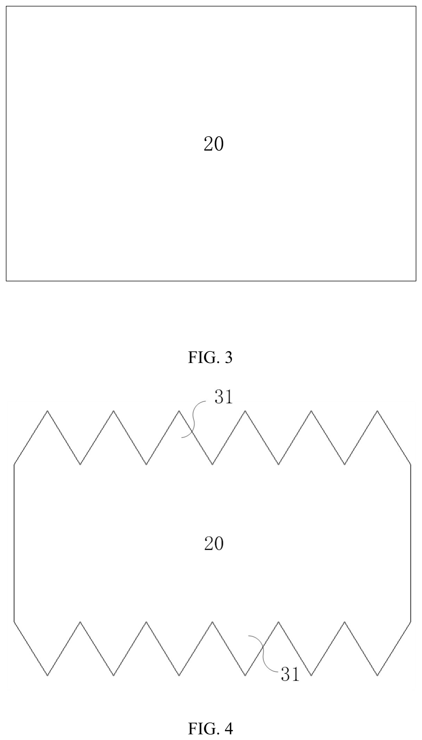

As shown in FIG. 3, the substrate 20 can be a substrate made of a semiconductor material, such as a silicon substrate, a silicon-germanium substrate, or a germanium substrate. The substrate 20 can be an N-type substrate or a P-type substrate. Both the front side and the back side of the substrate 20 are relatively flat surfaces.

The substrate 20 provided in embodiments is a silicon substrate 20. The substrate 20 is doped with ions of N-type conductivity, i.e., the substrate 20 is an N-type substrate.

As shown in FIG. 4, the substrate 20 is textured to remove a damaged layer on the surface of the substrate 20 and to form the first pyramid structure 31 on the front side of the substrate 20. In the embodiments, the first pyramid structure 31 is simultaneously formed on the back side of the substrate 20.

For example, a length of a base edge of the first pyramid structure 31 is in a range from 0.5 µm to 4 µm, and a height of the first pyramid structure 31 is in a range from 0.5 µm to 3 µm.

Step S102: forming an initial doped region on the front side of the substrate.

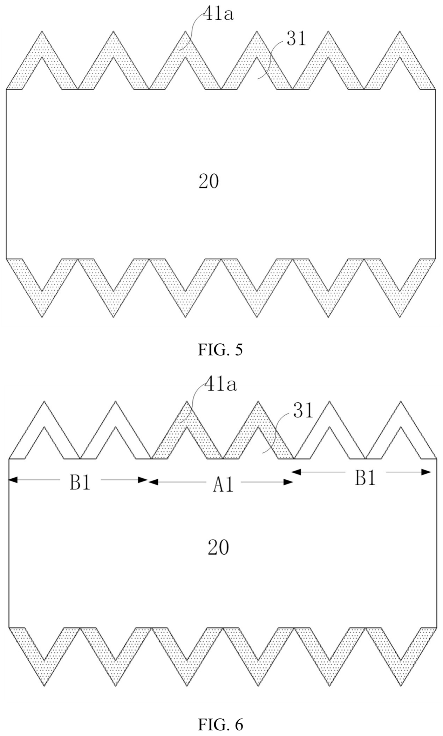

As shown in FIG. 5, the substrate 20 is placed in a diffusion furnace, and a boron source gas, such as BBr3, H₃BO₃, etc., is introduced into the diffusion furnace. The diffusion furnace is heated to decompose the boron source gas and release boron atoms. The boron atoms diffuse into the substrate 20, forming the initial doped region 41a in the first pyramid structures 31. The initial doped region 41a is enriched with P-type conductive boron ions.

Step S103: removing a portion of the initial doped region at intervals, wherein a region where the initial doped region is retained serves as a first region, a region where the initial doped region 41a is removed serves as a second region; and texturing the second region to form a second pyramid structure on the second region, wherein in a direction from a back side of the substrate towards the front side of the substrate, an apex of the first pyramid structure is higher than an apex of the second pyramid structure.

In the embodiments, removing a portion of the initial doped region 41a at intervals includes: irradiating the initial doped region 41a in the second region B1 with laser, and then texturing the second region B1 to remove the initial doped region 41a in the second region B1 and simultaneously form the second pyramid structure 32 on the second region B1.

In the above embodiments, during the texturing process in step S103, the texturing solution used can be an alkaline solution, such as an alkaline solution with a concentration of 1% to 5%, such as a 1% to 5% sodium hydroxide solution, or a 1% to 5% potassium hydroxide solution. In an example, the texturing solution is a 1.5% to 2.5% sodium hydroxide solution. In another example, the texturing solution is a 1% to 3% potassium hydroxide solution. The texturing process includes reacting at a temperature of 70°C to 90°C for 1 to 3 minutes.

As shown in FIG. 6, the initial doped region 41a on the front side is irradiated with laser to define the second regions B1 at intervals on the front side. The high-energy effect of the laser causes the material of the initial doped region 41a in the second region B1 to become loose.

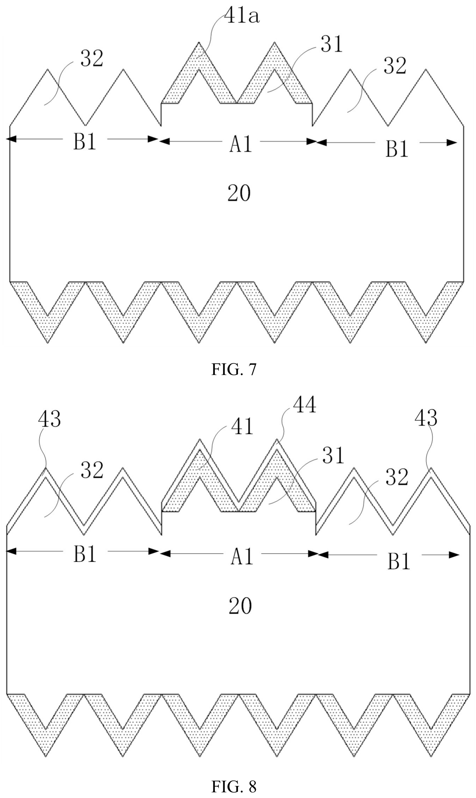

Then, as shown in FIG. 7, the second region B1 is textured. The substrate 20 is placed in a texturing solution to remove the initial doped region 41a in the second region B1, and meanwhile form the second pyramid structure 32 on the surface of the second region B1.

For example, a length of a base edge of the second pyramid structure 32 is in a range from 0.5 µm to 4 µm, and a height of the second pyramid structure 32 is in a range from 0.5 µm to 3 µm.

Since the initial doped region 41a in the second region B1 is removed, the apexes of the second pyramid structures 32 are lower than the apexes of the first pyramid structures 31, and the surface layer of the second pyramid structures 32 is the silicon substrate, lifetime loss of minority carriers caused by Auger recombination is effectively reduced, and the photoelectric conversion efficiency of the cell is also improved.

Step S104: performing a drive-in diffusion on the initial doped region to form a first diffusion-doped region in the first pyramid structure.

Referring to FIG. 8, the substrate 20 can be placed in a high-temperature quartz tube furnace and heated to a preset temperature (e.g., can be 800°C to 1200°C) to allow the boron ions in the initial doped region 40a to further diffuse inward into the substrate 20, forming the first diffusion-doped region 41.

Step S105: sequentially forming a tunnel layer, an intrinsic semiconductor layer, and a second silicon glass layer on the back side of the substrate.

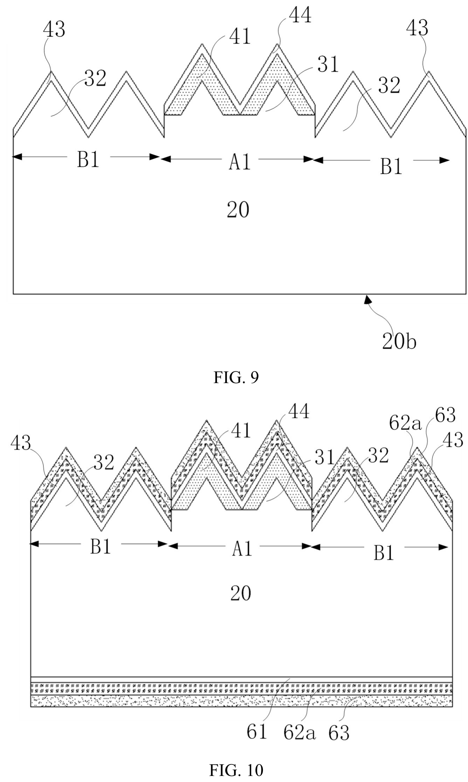

As shown in FIG. 9, first, the back side of the substrate 20 is polished to expose the surface of the substrate 20 and polish the back side of the substrate 20 into a flat plane.

Then, as shown in FIG. 10, an atomic layer deposition (ALD) process or a chemical vapor deposition (CVD) process can be used to sequentially deposit the tunnel layer 61, the intrinsic semiconductor layer 62a, and the second silicon glass layer 63 on a side of the tunnel layer 61 away from the substrate 20.

A thickness of the tunnel layer 61 is controlled to be 1 nm to 2 nm. The tunnel layer 61 is specifically a silicon oxide layer. The material of the intrinsic semiconductor layer 62a includes polysilicon. A thickness of the intrinsic semiconductor layer 62a is 100 nm to 300 nm.

In the embodiments, the second silicon glass layer 63 is a phosphosilicate glass layer.

Step S106: doping the intrinsic semiconductor layer to form a doped semiconductor layer.

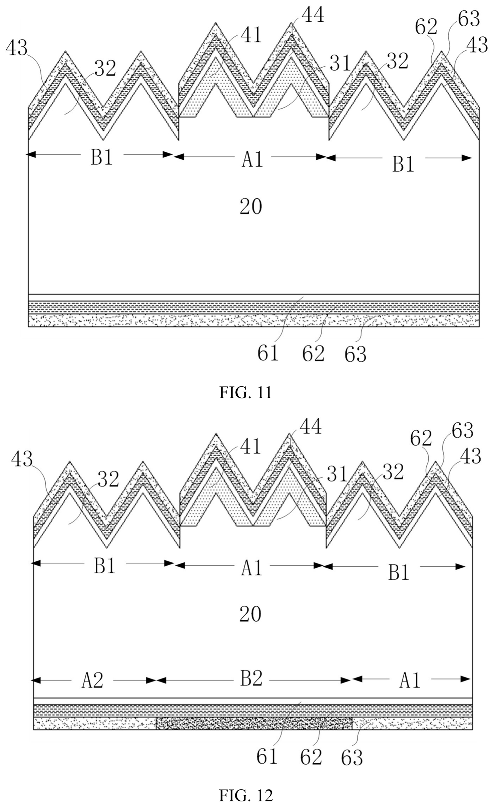

As shown in FIG. 11, the intrinsic semiconductor layer 62a can be subjected to high-temperature annealing to allow phosphorus ions in the second silicon glass layer 63 to diffuse into the intrinsic semiconductor layer 62a, forming the doped semiconductor layer 62.

Step S107: removing a portion of the tunnel layer, the doped semiconductor layer, and the second silicon glass layer that are stacked on the back side of the substrate at intervals, wherein a region where the tunnel layer, the doped semiconductor layer, and the second silicon glass layer are retained serves as a third region, and a region where the tunnel layer, the doped semiconductor layer, and the second silicon glass layer are removed serves as a fourth region.

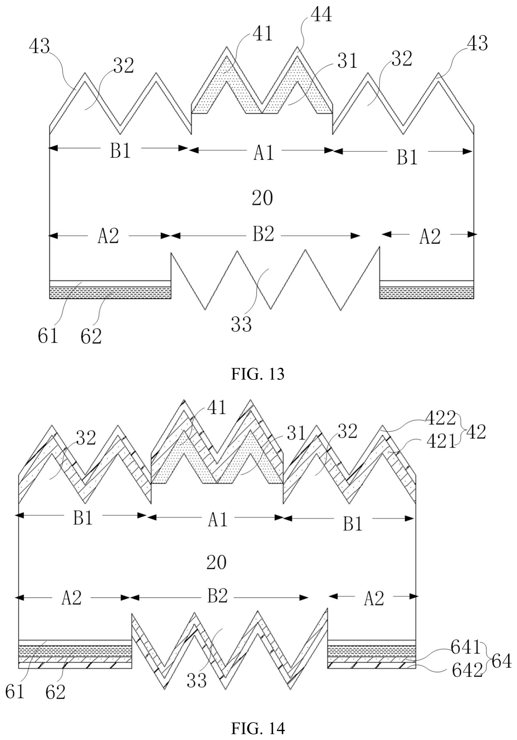

As shown in FIGS. 12 and 13, removing a portion of the tunnel layer 61, the doped semiconductor layer 62, and the second silicon glass layer 63 that are stacked on the back side of the substrate 20 at intervals includes: irradiating the tunnel layer 61, the doped semiconductor layer 62, and the second silicon glass layer 63 on the fourth region B2 with laser; removing the second silicon glass layer 63 on the fourth region B2 by washing with an acidic solution; and removing the tunnel layer 61 and the doped semiconductor layer 62 on the fourth region B2 during texturing the fourth regions B2.

The second silicon glass layer 63 on the back side is irradiated with laser, and the material of the second silicon glass layer 63 irradiated by the laser becomes loose, defining the fourth regions B2 at intervals on the back side. Then, the back side of the substrate 20 is washed with an acid solution to remove the second silicon glass layer 63 on the fourth regions B2, exposing the doped semiconductor layer 62 on the fourth regions B2.

In some embodiments, during washing the back side of the substrate 20 with an acid solution, the acid solution used can be a solution of hydrofluoric acid, such as a hydrofluoric acid solution with 5% to 10% of hydrofluoric acid.

Step S108: texturing the fourth region to form a third pyramid structure on the fourth region.

As shown in FIG. 13, the substrate 20 is placed in a texturing solution to remove the doped semiconductor layer 62 and the tunnel layer 61 on the fourth region B2, and meanwhile forming the third pyramid structure 33 on the surface of the fourth region B2. The third pyramid structure 33 can reduce reflective light loss on the fourth region B2. More light incident on the back side of the cell is converted into electric energy, improving the short-circuit current output and overall photoelectric conversion efficiency of the solar cell, and improving the bifaciality of the solar cell.

For example, a length of a base edge of the third pyramid structure 33 is in a range from 0.5 µm to 4 µm, and a height of the third pyramid structure 33 is in a range from 0.5 µm to 3 µm.

In the above embodiments, during the texturing process in step S108, the texturing solution used can be an alkaline solution, such as an alkaline solution with a concentration of 1% to 5%, such as a 1% to 5% sodium hydroxide solution, or a 1% to 5% potassium hydroxide solution. In an example, the texturing solution is a 1.5% to 2.5% sodium hydroxide solution. In another example, the texturing solution is a 1% to 3% potassium hydroxide solution. The texturing process includes reacting at a temperature of 70°C to 90°C for 1 to 3 minutes.

Step S109: removing the second silicon glass layer on the third region.

As shown in FIG. 13, in the embodiments, the second silicon glass layer 63 on the third region A2 is corroded and removed during texturing the fourth region B2.

In other embodiments, the second silicon glass layer 63 on the third region A2 can be retained, which is not limited in the present technical solution.

Step S110: forming a front passivation layer to cover the first diffusion-doped region of the first region and the substrate in the second region, and forming a back passivation layer to cover the doped semiconductor layer on the third region and the substrate in the fourth region.

As shown in FIG. 14, the front passivation layer 42 and the back passivation layer 64 can be formed by ALD process or CVD process. The front passivation layer 42 and the back passivation layer 64 can be one or more of aluminum oxide, silicon nitride, silicon oxynitride, etc. The front passivation layer 42 and the back passivation layer 64 can be formed in the same process.

Step S111: forming a first electrode on the first region, the first electrode being electrically connected to the first diffusion-doped region.

Referring to FIG. 1, a conductive paste is printed on the front passivation layer 42 of the first region A1 by screen printing, and dried to form the first electrode 50. Then, the first electrode 50 is irradiated with laser to electrically connect the first electrode 50 to the first diffusion-doped region 41 on the first region A1.

Step S112: forming a second electrode on the third region, the second electrode being electrically connected to the doped semiconductor layer.

Referring to FIG. 1, a conductive paste is printed on the back passivation layer 64 of the third region A2 by screen printing, and dried to form the second electrode 70. Then, the second electrode 70 is irradiated with laser to electrically connect the second electrode 70 to the doped semiconductor layer 62 on the third region A2.

In some embodiments, as shown in FIG. 8, after performing the drive-in diffusion on the initial doped region 41a, an oxide layer 53 is formed on a surface of the second region B1, and simultaneously a first silicon glass layer 54 is formed on a side of the first diffusion-doped region 41 away from the substrate 20. Specifically, the substrate 20 can be thermally oxidized to form the oxide layer 53 on the surface of the second region B1 and form the first silicon glass layer 54 on the side of the first diffusion-doped region 41 away from the substrate 20. In the embodiments, the first silicon glass layer 54 is a borosilicate glass layer. The oxide layer 53 and the first silicon glass layer 54 are formed to protect the front side of the substrate 20, avoiding damage to the front side of the substrate 20 during processing the back side of the substrate 20.

In the embodiments, at the same time of removing the tunnel layer 61 and the doped semiconductor layer 62 on the fourth region B2, the oxide layer 53 and the first silicon glass layer 54 are removed.

In the manufacturing method for the solar cell according to the embodiments, by performing front boron diffusion on the front side of the substrate 20 to form the initial doped region 40a, then using laser irradiation on the initial doped region 40a to define the first regions A1 and the second regions B 1, and removing the initial doped region 40a in the second regions B1 by texturing process, so that after subsequent boron diffusion agin, the first diffusion-doped region 41 is only formed in the first region A1, lifetime loss of minority carriers caused by Auger recombination can be reduced and the photoelectric conversion efficiency of the cell can also be improved. In the embodiments, the oxide layer 53 is used to protect the front side of the substrate 20, phosphorus diffusion treatment is performed on the back side of the cell to form the doped semiconductor layer 62, then laser irradiation and texturing treatment are performed on the back side of the substrate 20 to remove the doped semiconductor layer 62 on the fourth region B2, so that the doped semiconductor layer 62 on the third region A2 is retained, thereby improving the bifaciality of the cell and reducing parasitic light absorption.

In the manufacturing method for the solar cell according to the embodiments, by forming the first diffusion-doped region 41 in the first region A1 and forming the doped semiconductor layer 62 on the third region A2, the process window becomes larger and more controllable, which reduces process difficulty and cost. Through step-by-step preparation, the metallized regions on the front and back sides can be optimized separately, improving the overall performance of the cell.

The manufacturing method for the solar cell according to the embodiments not only reduces parasitic light absorption, but also improves the bifaciality of the cell through the design of double-sided texturing, enabling the cell to maintain high photoelectric conversion efficiency under different illumination conditions.

## Claims

1. A solar cell, comprising:
a substrate (20), wherein a front side of the substrate (20) comprises a first region (A1) and a second region (B1) that are arranged alternately, wherein the first region (A1) has a first pyramid structure (31), the second region (B1) has a second pyramid structure (32), and in a direction from a back side of the substrate (20) towards the front side of the substrate (20), an apex of the first pyramid structure (31) is higher than an apex of the second pyramid structure (32), the first region (A1) has a first diffusion-doped region (41); the back side of the substrate (20) comprises a third region (A2) and a fourth region (B2) that are arranged alternately, the solar cell comprises a tunnel layer (61) and a doped semiconductor layer (62) sequentially stacked on a side of the third region away from the substrate, and the fourth region (B2) has a third pyramid structure (33);
a first electrode (50) disposed on the first region (A1), the first electrode (50) being electrically connected to the first diffusion-doped region (41); and
a second electrode (70) disposed on the third region (A2), the second electrode (70) being electrically connected to the doped semiconductor layer (62).

2. The solar cell according to claim 1, further comprising:
a front passivation layer (42) disposed on the front side of the substrate (20), the front passivation layer (42) covering the first diffusion-doped region (41) of the first region (A1) and the substrate (20) in the second region (B1); and
a back passivation layer (64) disposed on the back side of the substrate (20), the back passivation layer (64) covering the doped semiconductor layer (62) on the third region (A2) and the substrate (20) in the fourth region (B2).

3. The solar cell according to claim 1 or 2, wherein a projection of the first region (A1) on the substrate (20) and a projection of the fourth region (B2) on the substrate (20) have an overlapping region, and a projection of the second region (B1) on the substrate (20) and a projection of the third region (A2) on the substrate (20) have an overlapping region.

4. The solar cell according to any one of claims 1 to 3, wherein a width of the first region (A1) is in a range from 80 µm to 300 µm, a width of the second region (B1) is in a range from 450 µm to 900 µm, a width of the third region (A2) is in a range from 80 µm to 300 µm, and a width of the fourth region (B2) is in a range from 450 µm to 900 µm.

5. The solar cell according to claim 4, wherein a ratio of the width of the first region (A1) to the width of the second region (B1) is in a range from 1:1 to 1:9, and a ratio of the width of the third region (A2) to the width of the fourth region (B2) is in a range from 1:1 to 1:9.

6. The solar cell according to any one of claims 1 to 5, wherein a size of a base of the first pyramid structure (31) is larger than a size of a base of the second pyramid structure (32), and a height of the first pyramid structure (31) is greater than a height of the second pyramid structure (32).

7. The solar cell according to any one of claims 1 to 6, wherein a length of a base edge of the third pyramid structure (33) is in a range from 0.5 µm to 4 µm, and a height of the third pyramid structure (33) is in a range from 0.5 µm to 3 µm.

8. The solar cell according to any one of claims 1 to 7, wherein a length of a base edge of the first pyramid structure (31) is in a range from 0.5 µm to 4 µm, and a height of the first pyramid structure (31) is in a range from 0.5 µm to 3 µm.

9. The solar cell according to any one of claims 1 to 8, wherein a length of a base edge of the second pyramid structure (32) is in a range from 0.5 µm to 4 µm, and a height of the second pyramid structure (32) is in a range from 0.5 µm to 3 µm.

10. The solar cell according to any one of claims 2 to 9, wherein the front passivation layer (42) comprises one or more of an aluminum oxide layer, a silicon oxide layer, or a silicon nitride layer;
the back passivation layer (64) comprises one or more of an aluminum oxide layer, a silicon oxide layer, or a silicon nitride layer.

11. The solar cell according to any one of claims 2 to 10, wherein the front passivation layer (42) comprises a first front passivation layer (421) and a second front passivation layer (422) sequentially stacked on the front side of the substrate (20);
the back passivation layer (64) comprises a first back passivation layer (641) and a second back passivation layer (642) sequentially stacked on the back side of the substrate (20).

12. The solar cell according to any one of claims 1 to 11, wherein a projection of the first region (A1) on the substrate (20) falls within a range of a projection of the fourth region (B2) on the substrate (20); and
a projection of the third region (A2) on the substrate (20) falls within a range of a projection of the second region (B1) on the substrate (20).

13. A method for manufacturing the solar cell according to any one of claims 1 to 12, comprising:
providing a substrate, and texturing a front side of the substrate to form a first pyramid structure;
forming an initial doped region on the front side of the substrate;
removing a portion of the initial doped region at intervals, wherein a region where the initial doped region is retained serves as a first region, a region where the initial doped region is removed serves as a second region; and texturing the second region to form a second pyramid structure on the second region, wherein in a direction from a back side of the substrate towards the front side of the substrate, an apex of the first pyramid structure is higher than an apex of the second pyramid structure;
performing a drive-in diffusion on the initial doped region to form a first diffusion-doped region in the first pyramid structure;
sequentially forming a tunnel layer, an intrinsic semiconductor layer, and a second silicon glass layer on the back side of the substrate;
doping the intrinsic semiconductor layer to form a doped semiconductor layer;
removing a portion of the tunnel layer, the doped semiconductor layer, and the second silicon glass layer that are stacked on the back side of the substrate at intervals, wherein a region where the tunnel layer, the doped semiconductor layer, and the second silicon glass layer are retained serves as a third region, and a region where the tunnel layer, the doped semiconductor layer, and the second silicon glass layer are removed serves as a fourth region;
texturing the fourth region to form a third pyramid structure on the fourth region;
removing the second silicon glass layer on the third region;
forming a front passivation layer to cover the first diffusion-doped region of the first region and the substrate in the second region, and forming a back passivation layer to cover the doped semiconductor layer on the third region and the substrate in the fourth region;
forming a first electrode on the first region, the first electrode being electrically connected to the first diffusion-doped region; and
forming a second electrode on the third region, the second electrode being electrically connected to the doped semiconductor layer.

14. The method according to claim 13, wherein removing a portion of the initial doped region at intervals comprises: irradiating the initial doped region in the second region with laser, and then texturing the second region to remove the initial doped region in the second region and simultaneously form the second pyramid structure on the second region;
removing a portion of the tunnel layer, the doped semiconductor layer, and the second silicon glass layer that are stacked on the back side of the substrate at intervals comprises: irradiating the tunnel layer, the doped semiconductor layer, and the second silicon glass layer on the fourth region with laser, removing the second silicon glass layer on the fourth region by washing with an acidic solution, and removing the tunnel layer and the doped semiconductor layer on the fourth region during texturing the fourth region.

15. The method according to claim 14, wherein after performing the drive-in diffusion on the initial doped region, an oxide layer is formed on a surface of the second region, and simultaneously a first silicon glass layer is formed on a side of the first diffusion-doped region away from the substrate;
at the time of removing the tunnel layer and the doped semiconductor layer on the fourth region, the oxide layer and the first silicon glass layer are removed.
